# EUROPEAN PATENT APPLICATION

(11) **EP 4 089 719 A1**
(43) Date of publication of application: **16.11.2022**
(21) Application number: 21173341.5
(22) Date of filing: 11.05.2021
(51) Int. Cl.: H01L 21/02, H01L 21/265

(54) **METHOD FOR PRODUCING A SILICON CARBIDE SUBSTRATE**

(71) Applicant: Hitachi Energy Switzerland AG, 5400 Baden (CH)
(72) Inventor: ALFIERI, Giovanni, 5400 Baden (CH); MIHAILA, Andrei, 5415 Rieden (CH)
(74) Representative: Epping - Hermann - Fischer

(57) **Abstract**

A method for producing a silicon carbide substrate (11) comprises providing the silicon carbide substrate (11) and irradiating the silicon carbide substrate (11) with particles (14) out of a group comprising electrons, hydrogen atoms, helium atoms, lithium atoms, beryllium atoms, boron atoms, sodium atoms, magnesium atoms and aluminum atoms. An energy of the particles (14) for irradiation is selected such that a resistivity (p) is increased by the irradiation at least in a part of the silicon carbide substrate (11) and the silicon carbide substrate (11) is semiconducting after irradiation.

## Description

The present disclosure relates to a method for producing a silicon carbide substrate.

Power semiconductor devices are often realized as high-voltage devices which usually require a thick, lightly doped layer. The thick, lightly doped layer can be fabricated as a silicon carbide layer, abbreviated SiC layer. Silicon carbide (abbreviated SiC) is a wide band gap semiconductor. This layer can be realized as an epitaxial layer, abbreviated epilayer. For example, 100 µm thick lightly doped SiC epilayers (∼10¹⁴ cm⁻³) are available. Power semiconductor devices which block voltages higher than 10 kV need an epilayer with a thickness larger than 100 µm with a doping concentration n ≤ 10¹⁴ cm⁻³ (resulting in a resistivity of 10⁵ Ω cm). However, thick SiC epilayers are expensive.

Alternatively, a thick, lightly doped layer can be realized as a semi-insulating silicon carbide layer or substrate, abbreviated SI-SiC layer or substrate. However, SI-SiC has a high resistivity (resistivity = 10⁹ Ω cm) compared to an example of a SiC epilayer (resistivity about 0.1 - 10 Ω cm). Bipolar diodes with a SI-SiC drift layer showed low forward currents in the µA range.

Document US 4201598 refers to an electron irradiation process of glass passivated semiconductor devices for improved reverse characteristics.

Document US 6974720 B2 relates to a method of forming power semiconductor devices using boule-grown silicon carbide drift layers.

There is a need for a method for producing a silicon carbide substrate having an appropriate resistivity.

According to an embodiment, a method for producing a silicon carbide substrate comprises providing a silicon carbide substrate and irradiating the silicon carbide substrate with particles. The particles are out of a group comprising electrons, hydrogen atoms, helium atoms, lithium atoms, beryllium atoms, boron atoms, sodium atoms, magnesium atoms and aluminum atoms. An energy of the particles for irradiation is selected such that a resistivity is increased by the irradiation at least in a part of the silicon carbide substrate and the silicon carbide substrate is semiconducting after irradiation.

Exemplarily, the irradiation by particles induces e.g. an increase of a concentration of silicon vacancies and of carbon vacancies in the silicon carbide substrate (abbreviated SiC substrate). These vacancies are point defects. The silicon vacancies can e.g. combine with the n-doping. The n-doping typically results from nitrogen. Nitrogen sits at a carbide site. Carbon vacancies do not combine to the nitrogen doping. For these reasons, a silicon vacancy causes doping passivation and a carbon vacancy causes carrier compensation. Therefore, a concentration of free electrons in the SiC substrate is reduced by the irradiation. Thus, the irradiation results in a passivation of present dopants and not in a counterdoping. In the text, the process of irradiating is named irradiation. Irradiation means irradiating the silicon carbide substrate with particles. Thus, the resistivity is increased at least in a part of the SiC substrate by the irradiation. At least this part of the SiC substrate is semiconducting after irradiation.

According to a further embodiment, a resistivity is increased by the irradiation in the whole SiC substrate. The whole SiC substrate may also be named total or complete SiC substrate.

According to a further embodiment, the resistivity is increased up to a range between 10² Ω cm and 10⁵ Ω cm by the irradiation. A SiC substrate with a resistivity in a range between 10² Ω cm and 10⁵ Ω cm may be called semiconducting. A doping concentration may be in a range between 10¹⁴ cm⁻³ and 10¹⁶ cm⁻³.

According to a further embodiment, before irradiating the SiC substrate, the SiC substrate is a conducting SiC substrate. Exemplarily, a conducting SiC substrate has a resistivity of equal or lower than 10⁻² Ω cm. The doping concentration for a conducting SiC substrate may be equal to or more than 10¹⁸ cm⁻³. Exemplarily, doping atoms are one of nitrogen or phosphor.

According to a further embodiment, the whole SiC substrate has an n-type conductivity before and after irradiation.

According to a further embodiment, the silicon carbide substrate is not attached to a carrier wafer before and during irradiation.

According to an alternative embodiment, the silicon carbide substrate is attached to a carrier wafer such as at least one of a silicon wafer and a glass wafer before and during irradiation.

According to a further embodiment, the silicon carbide substrate is free from a silicon carbide epitaxial layer.

According to a further embodiment, the method comprises annealing the silicon carbide substrate after irradiation.

Exemplarily, the method for producing a SiC substrate can be used for the manufacture of a semiconducting SiC substrate. The particle irradiation results in an increase of the resistivity of the SiC substrate. The semiconducting SiC substrate is an alternative to both a semi-insulating SiC substrate and a thick, lightly doped semiconducting SiC epilayer.

According to a further embodiment, the SiC substrate can be thick (e.g. 350 µm) and can be mechanically thinned down e.g. to 100 µm, if needed. The resistivity of such a SiC substrate can be increased from 10⁻² Ω cm to the 10²-10⁵ Ω cm range so to have moderately resistive SiC for high-voltage applications.

According to a further embodiment, the energy of the particles for irradiation is selected such that at least a part of the particles pass through the SiC substrate. Since particles pass through the SiC substrate, a high homogeneity of e.g. net doping concentration, carrier lifetime, resistivity and other parameters of the SiC substrate can be achieved.

According to a further embodiment, a power semiconductor device can be made of the SiC substrate. The power semiconductor device can be implemented for example as one of a thyristor, a diode, a gate turn-off thyristor (abbreviated GTO), a power metal-insulating-semiconductor field-effect transistor (abbreviated power MISFET), a power metal-oxide-semiconductor field-effect transistor (abbreviated power MOSFET), a junction field-effect transistor (abbreviated JFET), a bipolar junction transistor (abbreviated BJT), an insulated-gate bipolar transistor (abbreviated IGBT) and an integrated gate-commutated thyristor (abbreviated IGCT). Thus, the SiC substrate can be used for the production of bipolar and/or MOS chips or devices. Particle irradiation is used to modulate the resistivity of conducting SiC substrates. Conducting SiC substrates may be thick and are less expensive. They have e.g. a thickness of 350 µm. Thus, the proposed SiC substrate is a cost-effective material for high-voltage applications. The irradiation can be carried out on a boule level, meaning that the boule can then be cut out on-axis; thus, material waste is reduced.

In order to increase the resistivity of a conducting SiC substrate, that is making a semiconducting SiC substrate, a particle irradiation is used. In this way, irradiation induced defects (silicon-related) can passivate a nitrogen doping. Indeed, irradiation induced defects (carbon-related) can trap charge carriers. However, the latter effect is not the main one when doping levels are high, e.g. higher than 10¹⁶ cm⁻³.

The present disclosure comprises several aspects of a method for producing a SiC substrate. Every feature described with respect to one of the aspects is also disclosed herein with respect to the other aspect, even if the respective feature is not explicitly mentioned in the context of the specific aspect.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.
Figures 1, 2A and 2B are views of a silicon carbide substrate and of an irradiation arrangement according to different embodiments.
Figure 3A and 3B are schematics of a method for producing a silicon carbide substrate according to different embodiments.
Figures 4A and 4B are values of a method for producing a silicon carbide substrate according to different embodiments.
Figures 5 and 6 are characteristics of a silicon carbide substrate according to an embodiment.

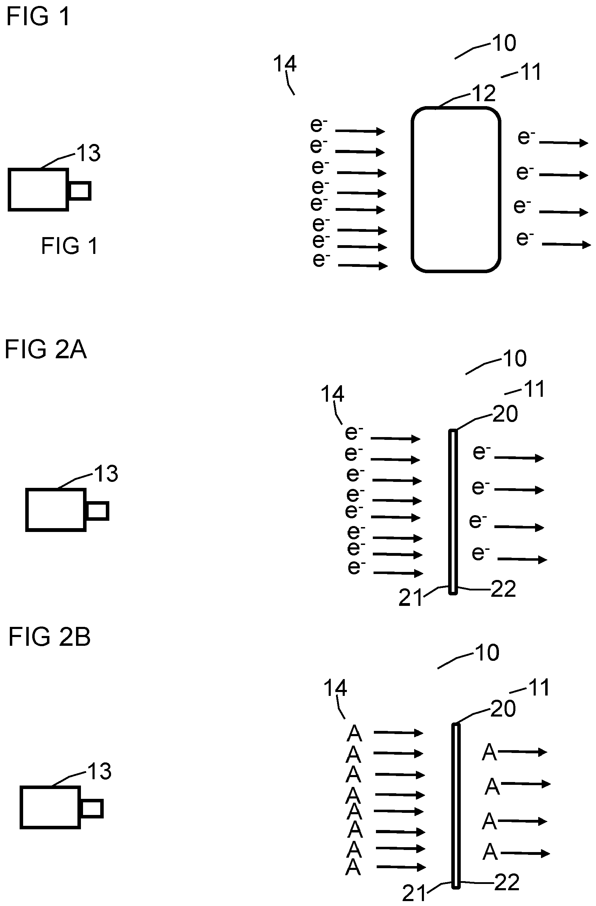

Figure 1 is a view of a silicon carbide substrate 11 and of an irradiation arrangement 10 according to an embodiment. The silicon carbide substrate 11 is realized as silicon carbide boule 12, abbreviated SiC boule. After irradiating the SiC boule 12, the SiC boule 12 is sawn into wafers. The SiC boule 12 typically has a cylinder form. The SiC boule 12 is fabricated e.g. using a seeded sublimation growth technique, a high-temperature chemical vapor deposition technique (abbreviated high-temperature CVD technique) or another technique. A 4H-SiC polytype substrate can be obtained using seeded sublimation growth. The irradiation of a silicon carbide boule can be performed from a lateral side, i.e. a side through the length axis of the SiC boule 12, which is exemplarily a side perpendicular to the sawing direction.

The irradiation arrangement 10 comprises the SiC substrate 11 and an irradiation source 13. The irradiation source 13 is realized e.g. as an electron gun and/or an accelerator. Particles 14 with a high kinetic energy are provided by the irradiation source to the silicon carbide substrate 11. In this example, the particles 14 are electrons, indicated as e⁻ in Figure 1. The energy of the particles 14 for irradiation is high enough that at least a part of the particles 14 pass through the SiC substrate 11. Particles 14 for irradiation are electrons. In an example, 50 % of the particles 14 pass the SiC substrate 11. Alternatively, 75 % or 90 % of the particles 14 pass the SiC substrate 11. Optionally, most of the electrons go through the SiC substrate 11.

Figure 2A is a view of a SiC substrate 11 and of an irradiation arrangement 10 according to a further embodiment which is a further development of the embodiment shown in Figure 1. The SiC substrate 11 is realized as a silicon carbide wafer 20 (abbreviated SiC wafer) having a first main side 21 and a second main side 22. During irradiating the SiC substrate 11, the particles 14 enter the first main side 21 of the SiC wafer 20. Optionally, at least a part of the particles 14 leave the SiC wafer 20 at the second main side 22.

The particles 14 for irradiation are electrons, indicated as e⁻ in Figure 2A. The electrons have e.g. an energy in a range between 140 keV and 180 keV. The particles 14 for irradiation being electrons have a dose e.g. in a range between 0.5·10¹⁷ cm⁻² and 2·10¹⁹ cm⁻². Alternatively, the particles 14 for irradiation being electrons have a dose e.g. in a range between 10¹⁷ cm⁻² and 10¹⁹ cm⁻². In an example, the SiC substrate 11 is not attached to a carrier wafer such as a silicon wafer or a glass wafer before and during irradiation. The SiC substrate 11 is free from a SiC epitaxial layer. The SiC wafer 20 is e.g. a 4H-SiC wafer.

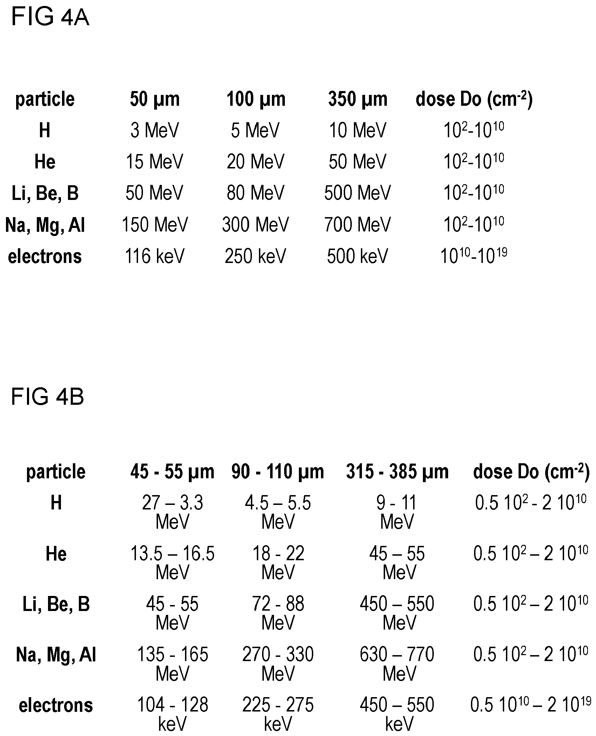

Figure 2B is a view of a silicon carbide substrate 11 and of an irradiation arrangement 10 according to a further embodiment which is a further development of the embodiment shown in Figures 1 and 2A. The particles 14 for irradiation are atoms, indicated as A in Figure 2B. The atoms are ionized. Examples for atoms are hydrogen atoms, helium atoms, lithium atoms, beryllium atoms, boron atoms, sodium atoms, magnesium atoms and aluminum atoms. Doses and energies are described below in lists in Figures 4A and 4B. The irradiation source 13 is implemented e.g. as an accelerator. An example of an accelerator is an ion implanter. The implanter is e.g. realized as a high energy ion implanter. The energy of the particles 14 for irradiation may be high enough that at least a part of the particles 14 pass through the SiC substrate 11. Particles 14 for irradiation are atoms or ions. In an example, 50 % of the particles 14 pass the SiC substrate 11. Alternatively, e.g. 75 % or 90 % of the particles 14 pass the SiC substrate 11.

The use of electron irradiation and/or ion irradiation is performed in order to increase the resistivity of a SiC conducting substrate (with a resistivity of about 10⁻² Ohm cm) .

Depending on the energy of the particles, e.g. electrons, the resistivity may be increased only in a part of the silicon carbide substrate 11 so that a layer of the silicon carbide substrate 11 becomes semiconducting and another layer of the silicon carbide substrate 11 stays conducting. These layers are arranged perpendicular to the irradiation direction. The type of particles, exemplarily heavier particles, can also cause the effect of a creation of the silicon carbide substrate 11 with a conducting and a semiconducting layer to be more pronounced.

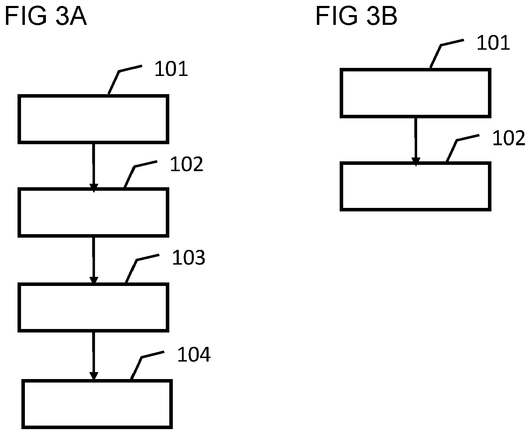

Figure 3A is a schematic of a method for producing a silicon carbide substrate 11 according to an embodiment which is a further development of the embodiment shown in Figures 1, 2A and 2B. The method comprises providing a SiC substrate 11 in a providing process 101 and irradiating the SiC substrate 11 with particles 14 out of a group comprising electrons, hydrogen atoms, helium atoms, lithium atoms, beryllium atoms, boron atoms, sodium atoms, magnesium atoms and aluminum atoms in an irradiation process 102. The net doping concentration of the electrons in the SiC substrate 11 is homogeneous before and after irradiation. The net donor concentration profile is homogeneous after irradiation. In an example, the irradiation process 102 results not in a typical ion implantation profile or results only in a flat distribution of the net donor concentration.

Thus, the method comprises providing the SiC substrate 11 as the SiC boule 12, and sawing the SiC boule 12 into wafers after irradiating the SiC boule 12. In an example, irradiating the SiC boule 12 is realized as irradiating the SiC boule 12 from a lateral side of the SiC boule 12.

As explained in Figure 1, in an example, the SiC substrate 11 is implemented as a SiC boule 12. Optionally, the method comprises annealing the SiC substrate 11 after irradiation in an annealing process 103. The method comprises sawing the SiC boule 12 into wafers in a sawing process 104.

During fabrication of a power semiconductor device using the SiC substrate 11, high temperature processes for oxidation or for annealing after an ion implantation step are performed. Thus, annealing can be performed in the annealing process 103 or later during fabrication of the power semiconductor device. The SiC substrate 11 is configured for fabrication of the power semiconductor device which is e.g. a high voltage insulated-gate bipolar transistor (abbreviated high voltage IGBT). A blocking voltage of the IGBT is larger e.g. than 5 kV or larger than 10 kV or larger than 20 kV.

The chronical order of the annealing process 103 and of the sawing process 104 can be the other way around.

In an example, the SiC boule 12 has a diameter in a range of 9 cm to 11 cm. The SiC boule 12 has e.g. a 4" diameter (∼ 10 cm). For example, the particles 14 for irradiation of the SiC boule 12 are electrons having an energy equal or higher than 1.5 MeV. The particles 14 for irradiation being electrons have a dose in a range between 10¹⁵ cm⁻² and 10¹⁹ cm⁻².

Figure 3B is a schematic of a method for producing a silicon carbide substrate 11 according to an embodiment which is a further development of the embodiment shown in Figures 1, 2A, 2B and 3A. The method comprises providing the SiC substrate 11 as a SiC wafer 20 in the providing process 101 and irradiating the SiC substrate 11 with particles 14 out of a group comprising electrons, hydrogen atoms, helium atoms, lithium atoms, beryllium atoms, boron atoms, sodium atoms, magnesium atoms and aluminum atoms in the irradiation process 102.

As explained in Figures 2A and 2B, in an example, the SiC substrate 11 is implemented as a SiC wafer 20. Optionally, the method comprises annealing the SiC substrate 11 after irradiation in an annealing process, not shown. Thus, annealing can be performed in the annealing process or later during fabrication of the power semiconductor device.

Therefore, the irradiation is performed after sawing a SiC boule into wafers. Optionally, the method comprises grinding or backgrinding the SiC wafer 20 before or after irradiation.

For example, the particles 14 for irradiation are electrons having an energy in a range between 140 keV and 180 keV. The particles 14 for irradiation being electrons have a dose in a range between 0.5·10¹⁷ cm⁻² and 2·10¹⁹ cm⁻², or alternatively a dose in a range between 10¹⁷ cm⁻² and 10¹⁹ cm⁻². By this irradiation an electron concentration of e.g. 10¹¹-10¹³ cm⁻³ can be achieved. In an example, the SiC wafer 20 has a thickness in a range of 80 µm and 120 µm, or between 90 µm and 110 µm.

For stabilization of a SiC wafer with low thickness, in an example, the SiC wafer 20 is optionally attached to a carrier wafer during irradiation. Alternatively, the irradiation is performed using a thick SiC wafer 20 which is then thinned to a desired thickness.

Figure 4A are values of a method for producing a SiC substrate 11 according to an embodiment which is a further development of the embodiments shown above. The SiC substrate 11 is a SiC wafer 20. In Figure 4A, example values are shown for different values of a thickness of a SiC wafer 20.

Figure 4B are values of a method for producing a SiC substrate 11 according to an embodiment which is a further development of the embodiments shown above. The SiC substrate 11 is a SiC wafer 20. In Figure 4A, a range of values are shown for different values of a thickness of the SiC wafer 20. The values were obtained by Montecarlo simulations.

In an example, the particles 14 for irradiation are electrons having an energy in a range between 450 keV and 550 keV at a thickness of the SiC wafer 20 in a range between 315 µm to 385 µm. The particles 14 for irradiation being electrons have a dose between 0.5·10¹⁰ cm⁻² and 2·10¹⁹ cm⁻² or alternatively between 10¹⁰ cm⁻² and 10¹⁹ cm⁻².

In a further example, the particles 14 for irradiation are hydrogen atoms having an energy in a range between 9 MeV and 11 MeV at a thickness of the SiC wafer 20 in a range between 315 µm to 385 µm. The particles 14 for irradiation being hydrogen atoms have a dose between 0.5·10² cm⁻² and 2·10¹⁰ cm⁻².

In an example, the particles 14 for irradiation are helium atoms having an energy in a range between 13.5 MeV and 16.5 MeV at a thickness of the silicon carbide wafer 20 in a range between 45 µm to 55 µm. The particles 14 for irradiation being helium atoms have a dose between 0.5·10² cm⁻² and 2·10¹⁰ cm⁻².

Further values of energy and doses for different atoms and values of a thickness of the SiC wafer 20 are disclosed in Figure 4B. The doses and energies are selected according to a power semiconductor device which is produced using the SiC wafer 20 as substrate.

In Figures 4A and 4B, a list of particles, energy and dose ranges are disclosed. For each particle, the irradiation energy for 50 µm, 100 µm and 350 µm thick SiC substrate 11 is described. In Figures 4A and 4B, the SiC substrate is a SiC wafer 20. The particles 14 are electrons and/or atoms. Since the atoms are ionized, the atoms are ions. Thus, one can say that the particles 14 are electrons and ions. A hydrogen ion can be named proton. A helium ion can be named alpha particle. As the tables show, particles 14 such as electrons, hydrogen and helium are appropriate for SiC wafers 20 having a thickness of 385 µm or less. The irradiation of SiC wafers 20 with a higher thickness can also be performed. Each of the particles 14 of the group comprising electrons, hydrogen atoms, helium atoms, lithium atoms, beryllium atoms, boron atoms, sodium atoms, magnesium atoms and aluminum atoms can be used, if the SiC wafer 20 has a thickness e.g. in a range between 5 µm and 10 µm. In an example, the SiC substrate 11 is thinned down to about 5 µm to 10 µm.

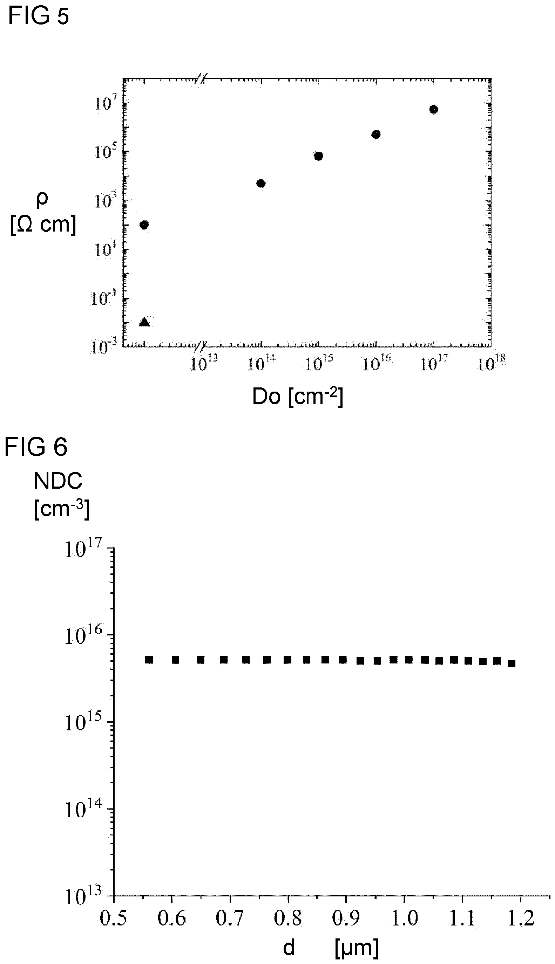

Figure 5 is a characteristic of a silicon carbide substrate 11 according to an embodiment which is a further development of the buff shown embodiments. In Figure 5, resistivity ρ of a low-energy electron irradiated SiC thin film is shown as a function of a dose Do. The circle symbol refers to values of a semiconducting SiC substrate 11. Resistivity ρ for a conducting SiC substrate 11 is also shown (triangle symbol).

In the present disclosure, electron irradiation/ion implantation is used in order to increase the resistivity of a SiC conducting substrate (about ∼10⁻² Ohm cm). The data shown in Figure 5 were achieved by performing an electrical characterization (I-V) of n-type 4H-SiC epilayers (100 µm thick, 3-5 · 10¹⁴ cm⁻³), irradiated by 160 keV electrons (penetration depth ∼120 µm) with four different doses (10¹⁴, 10¹⁵, 10¹⁶ and 10¹⁷ cm⁻²). As Figure 5 shows, by increasing the electron dose, the resistivity ρ increases up to almost five orders of magnitude. For instance, a dose of 10¹⁴ cm⁻², corresponds to an electron concentration of ∼10¹² cm⁻³. The experiment was performed on a 100 µm thick semiconducting epilayer grown on a conducting SiC substrate. The topmost 5 µm part of the epilayer was analyzed.

4H-SiC substrates have a doping level of 10¹⁸ cm⁻³ (ρ ∼ 10⁻² Ω cm). Following the results of Figure 5, in order to achieve an electron concentration of 10¹¹-10¹³ cm⁻³, for energies of 160 keV, doses ranging between 10¹⁷-10¹⁹ cm⁻² can be selected. If higher electron energies (>300 keV) or heavier particles 14 are used (hydrogen, helium), lower doses (<10¹⁴ -10¹⁶ cm⁻²) can be employed.

The increase of resistivity ρ can be correlated to the free carrier reduction (compensation), due to nitrogen electrical passivation. After irradiation/implantation compensation increases with nitrogen doping, because radiation induced point defects can migrate and passivate nitrogen. Exemplarily, the silicon carbide substrate 11 is doped with another n dopant like phosphor.

Figure 6 is a characteristic of a silicon carbide substrate 11 according to an embodiment which is a further development of the above shown embodiments. In Figure 6, a net donor concentration NDC as a function of a depth d of the SiC substrate 11 is shown. These values were determined by a capacitance voltage measurement on an irradiated 4H-SiC substrate 11. The irradiation results in a uniform net donor concentration profile of the SiC substrate 11.

Advantageously, it is more cost effective to buy SiC substrates than growing thick epilayers. Semi-insulating SiC substrates (abbreviated SI-SiC substrates) are too highly resistive (∼10⁹ Ω cm). Advantageously, the SiC semiconducting substrates 11 or wafers 20 can be mechanically thinned (∼100 µm).

The SiC substrate 11 can have the form of the SiC boule 12 or of the SiC wafer 20. One can determine whether the method for producing a SiC substrate 11 is used by checking and/or evaluating the SiC substrate 11 after irradiation: One can check whether or not a cathode of a power semiconductor device was formed by implantation (in case the cathode was formed by implantation, the SiC substrate 11 may have been produced using the described method). One can check the nitrogen content by secondary-ion mass spectrometry (abbreviated SIMS) (in case of a high nitrogen concentration and a low resistivity of a region, the SiC substrate may have been produced by the described method). One can measure a concentration [V_{C}] of carbon vacancies V_{C} of the drift layer) (in case of a high concentration of carbon vacancies V_{C} of the drift layer, the SiC substrate 11 may have been produced by the described method).

Irradiation leads to the formation of carbon vacancies Vc which trap carriers. This means that minority carrier lifetime is shortened. However, for doping concentrations > 10¹⁶ cm⁻³, carrier lifetime is at least 30% longer than for doping concentrations < 10¹⁶ cm⁻³.

The irradiation modifies the doping concentration for better blocking capability by increased resistivity, before the further fabrication processes to fabricate a power semiconductor device. Thus, the irradiation is performed before the further fabrication processes to fabricate the power semiconductor device which includes high temperature operations. These high temperature operations perform e.g. the annealing of a damage caused by the irradiation.

While the disclosure is amenable to various modifications and alternative forms, specifics thereof have been shown by way of example in the Figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

The embodiments shown in the Figures 1 to 6 as stated represent exemplary embodiments of the improved method for producing a SiC substrate; therefore, they do not constitute a complete list of all embodiments according to the improved method. Actual methods may vary from the embodiments shown in terms of processes, doses, energies, arrangements and devices for example.

### Reference Signs

- 10: arrangement
- 11: silicon carbide substrate
- 12: silicon carbide boule
- 13: irradiation source
- 14: particle
- 20: silicon carbide wafer
- 21: first main side
- 22: second main side
- 101: providing process
- 102: irradiation process
- 103: annealing process
- 104: sawing process
- d: depth
- Do: dose
- NDC: net donor concentration
- ρ: resistivity

## Claims

1. A method for producing a silicon carbide substrate (11), wherein the method comprises:
- providing the silicon carbide substrate (11) and
- irradiating the silicon carbide substrate (11) with particles (14) out of a group comprising electrons, hydrogen atoms, helium atoms, lithium atoms, beryllium atoms, boron atoms, sodium atoms, magnesium atoms and aluminum atoms, wherein an energy of the particles (14) for irradiation is selected such that a resistivity (p) is increased by the irradiation at least in a part of the silicon carbide substrate (11) and the silicon carbide substrate (11) is semiconducting after irradiation.

2. The method of claim 1, wherein the resistivity (p) is increased by the irradiation in the whole silicon carbide substrate (11).

3. The method of claim 1 or 2, wherein the resistivity (p) is increased up to a range between 10² Ω cm and 10⁵ Ω cm by the irradiation.

4. The method of one of claims 1 to 3, wherein before irradiating the silicon carbide substrate (11), the silicon carbide substrate (11) is a conducting silicon carbide substrate.

5. The method of one of claims 1 to 4, wherein the whole silicon carbide substrate (11) has an n-type conductivity before and after irradiation.

6. The method of one of claims 1 to 5, wherein providing the silicon carbide substrate (11) as a silicon carbide boule (12), and sawing the silicon carbide boule (12) into wafers after irradiating the silicon carbide boule (12).

7. The method of claim 6, wherein irradiating the silicon carbide boule (12) from a lateral side of the silicon carbide boule (12).

8. The method of one of claims 1 to 5, wherein providing the silicon carbide substrate (11) as a silicon carbide wafer (20) having a first main side (21) and a second main side (22), and
wherein during irradiating the silicon carbide substrate (11), the particles (14) enter the first main side (21) of the silicon carbide wafer (20).

9. The method of claim 8, wherein irradiating with electrons as the particles with at least one of
- a dose in a range between 0.5·10¹⁷ cm⁻² and 2·10¹⁹ cm⁻² or
- an energy in a range between 140 keV and 180 keV.

10. The method of claim 8, wherein the particles (14) for irradiation are electrons having an energy in a range between 450 keV and 550 keV and a thickness of the silicon carbide wafer (20) is in a range between 315 µm to 385 µm.

11. The method of claims 8 or 10, wherein irradiating with electrons as the particles with a dose between 0.5·10¹⁰ cm⁻² and 2·10¹⁹ cm⁻².

12. The method of claim 8, wherein irradiating with hydrogen atoms as the particles having an energy in a range between 9 MeV and 11 MeV and a thickness of the silicon carbide wafer (20) is in a range between 315 µm to 385 µm.

13. The method of claim 8 or 12, wherein irradiating with hydrogen atoms as the particles with a dose between 0.5·10² cm⁻² and 2·10¹⁰ cm⁻².

14. The method of claim 8, wherein irradiating with helium atoms as the particles with at least one of
- an energy in a range between 13.5 MeV and 16.5 MeV and a thickness of the silicon carbide wafer (20) in a range between 45 µm to 55 µm, or
- a dose between 0.5·10² cm⁻² and 2·10¹⁰ cm⁻².

15. The method of one of claims 1 to 14, wherein the silicon carbide substrate (11) is homogeneous before and after irradiation.
